Europäisches Patentamt

(19) European Patent Office

Office européen des brevets

(11) Numéro de publication: **0 167 431**

**B1**

(12) **FASCICULE DE BREVET EUROPÉEN**

(45) Date de publication du fascicule du brevet:
02.09.87

(51) Int. Cl.⁴: **H 02 M 1/08,** H 03 K 17/60

(21) Numéro de dépôt: **85401094.9**

(22) Date de dépôt: **04.06.85**

(54) **Circuit de commande de commutation avec isolement galvanique, et durées de conduction variables de zéro à l'infini.**

(30) Priorité: **06.06.84 FR 8408848**

(43) Date de publication de la demande:
**08.01.86 Bulletin 86/2**

(45) Mention de la délivrance du brevet:
**02.09.87 Bulletin 87/36**

(84) Etats contractants désignés:
**DE FR GB IT NL**

(56) Documents cité:
**FR-A-2 335 051**
**GB-A-2 095 943**

(73) Titulaire: **THOMSON- CSF, 173, Boulevard Haussmann, F-75379 Paris Cedex 08 (FR)**

(72) Inventeur: **Rischmuller, Klaus, THOMSON- CSF SCPI 173, bld Haussmann, F-75379 Paris Cedex 08 (FR)**

(74) Mandataire: **Guérin, Michel, THOMSON- CSF SCPI 19, avenue de Messine, F-75008 Paris (FR)**

## Description

La présente invention concerne les circuits de commande de composants semiconducteurs fonctionnant en commutation, par exemple des transistors de puissance, des montages Darlington, des thyristors, des thyristors blocables par la gâchette. Ces éléments de commutation sont utilisés pour la conversion d'énergie, par exemple pour réaliser des alimentations de postes de soudure, des variateurs de vitesse, des alimentations de secours etc...

Dans tout ce qui suit, on considère a titre d'exemple que le composant commandé est un transistor de puissance (commande par la base) mais l'invention est applicable aussi a d'autres composants tels que ceux qui sont indiqués ci-dessus.

Les convertisseurs d'énergie fonctionnent sur le principe très général d'une commutation d'un composant de puissance avec une fréquence et/ou un rapport cyclique de conduction variable dans de larges proportions. La commutation du composant est assurée par un circuit de commande qui reçoit un signal de commande ayant cette fréquence et ce rapport cyclique, et qui reçoit par ailleurs une énergie d'alimentation nécessaire à son fonctionnement.

Dans certaines applications on peut souhaiter répondre a deux contraintes particulières qui sont:

- d'une part, un isolement galvanique entre le circuit de commande de l'élément de commutation et le circuit d'élaboration du signal de commande proprement dit:

- d'autre part une possibilité de variation très large, si possible de zéro a l'infini, des durées de conduction et des durées de blocage du composant de commutation.

L'isolement galvanique est nécessaire par exemple lorsque le convertisseur d'énergie est un convertisseur en pont dans lequel au moins un composant doit avoir son émetteur a un potentiel flottant et non à un potentiel fixe de masse, ce qui rend sa commande plus difficile. L'isolement est aussi souhaitable pour des raisons de sécurité ou pour éviter qu'une panne d'un composant de puissance n'entraîne la destruction des circuits d'élaboration du signal de commande.

La variation très large du rapport cyclique ou de la fréquence, donc plus généralement des durées de conduction et de blocage, est utile par exemple pour des onduleurs à très basse fréquence.

Une autre contrainte à laquelle on désire répondre est aussi la possibilité non seulement d'appliquer un courant de commande de base (ou de gâchette) négatif pour le blocage du composant, mais encore de maintenir une polarisation négative sur cette base pendant toute la durée de blocage.

Les circuits de commande de commutation proposés jusqu'à maintenant ne répondent que partiellement à ces divers impératifs et présentent des inconvénients importants, notamment du point de vue du coût de réalisation et de la fiabilité de fonctionnement.

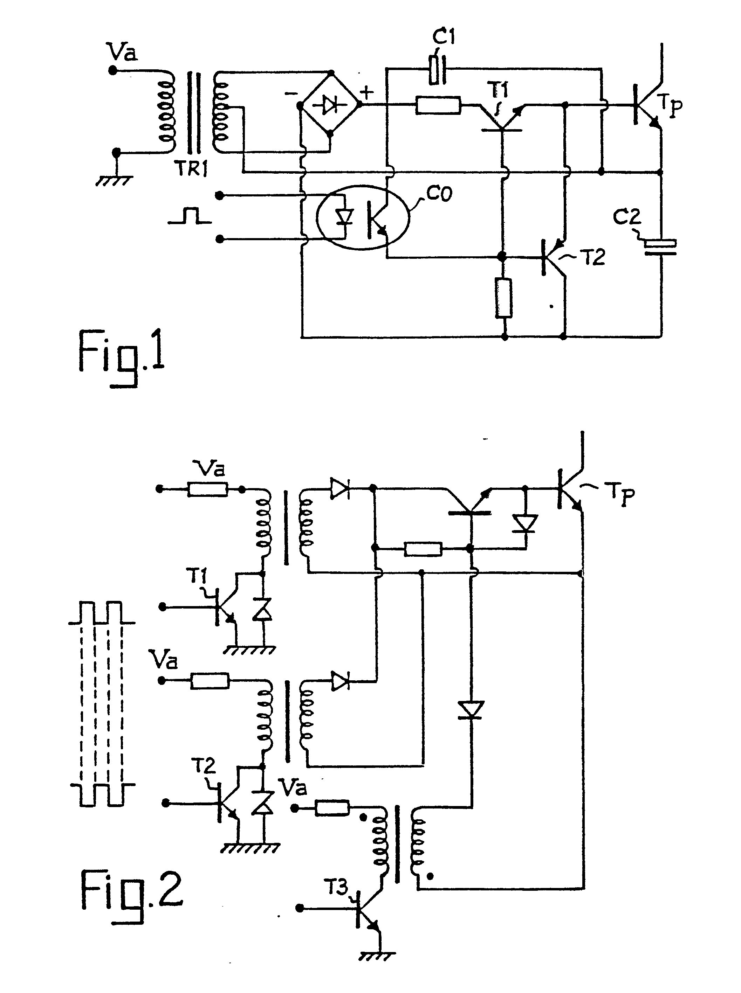

Ainsi, la figure 1 représente un exemple de circuit de commande d'un transistor de puissance Tp.

L'alimentation en énergie de ce circuit se fait à travers un transformateur d'isolement galvanique TR 1 recevant un courant alternatif à 50 Hz ou à plus haute fréquence (20 kilohertz par exemple).

Le secondaire du transformateur TR 1 est un enroulement ayant un point milieu relié à l'émetteur du transistor Tp.

La tension aux bornes du redresseur est redressée par un pont de diodes et filtrée par deux capacités C1 et C2. Le circuit de commande proprememt dit est constitué par deux transistors T 1 et T2 dont les émetteurs sont reliés à la base du transistor de puissance Tp. Les transistors T1 et T2 sont commandés par la sortie d'un coupleur optoélectronique CO recevant un signal de commande en tout ou rien et assurant la transmission de ce signal avec isolement galvanique. Lorsque le transistor T 1 est rendu conducteur par ce signal, le transistor T2 est bloqué et la base du transistor Tp reçoit un courant positif qui rend conducteur ce transistor.

Lorsque T1 est bloqué, T2 est rendu conducteur et un courant négatif est extrait de la base du transistor Tp qui est donc bloqué.

L'inconvenient de ce type de circuit est d'une part la lenteur de la transmission optique du signal de commande par le coupleur, d'autre part la sensibilité aux parasites susceptibles de déclencher intempestivement l'élément de commutation, et enfin la nécessite d'utiliser plusieurs coupleurs opto-électroniques dans le cas d'un convertisseur en pont.

Dans certains cas, le coupleur optoélectronique est remplacé par un petit transformateur attaqué en impulsions courtes positives et négatives et suivi d'une bascule bistable; la rapidité de transmission du signal de commande est plus grande mais la sensibilité aux parasites est également plus grande et son effet est encore plus gênant à cause de la bascule bistable qui peut maintenir un état incorrect pendant une durée longue (mémorisation de l'état imposé par un parasite).

Un autre type de circuit de commande est représenté à la figure 2. Il a l'avantage d'être peu sensible aux parasites mais il a l'inconvénient de nécessiter trois transformateurs pour chaque transistor a commuter; d'autre part il ne permet pas de maintenir une polarisation négative sur la base du transistor Tp lorsque celui-ci est bloqué. Ce schéma fonctionne de la manière suivante: trois transistors T1, T2, T3 commandent chacun un enroulement primaire de transformateur. T1 et T2 sont rendus conducteurs de manière alternée (à une fréquence élevée) pendant que T3 est bloqué; le transistor Tp reçoit alors un courant de base positif issu alternativement des transformateurs commanidés par T1 et T2 respectivememt. Tp est donc conducteur.

Pour bloquer Tp, on rend T3 conducteur pendant une courte durée, en même temps qu'on bloque T1 et T2. Un courant de base négatif temporaire est alors extrait de la base de Tp qui se bloque.

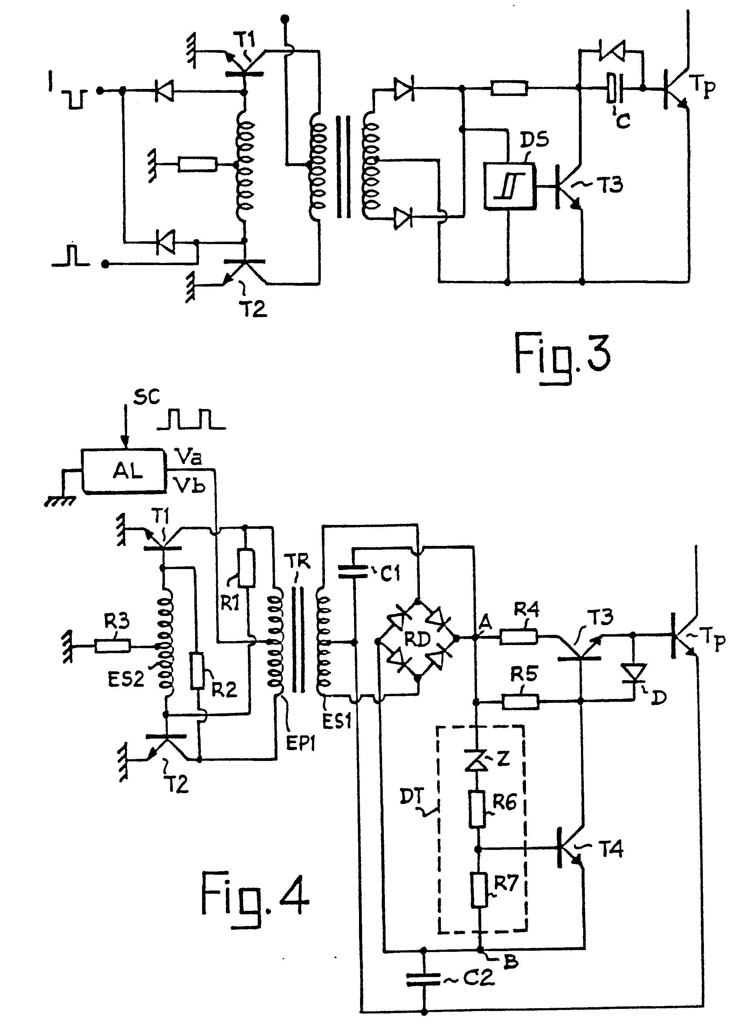

Un autre schéma de circuit de commande connu est représenté à la figure 3. Ce schéma n'utilise qu'un seul transformateur servant à transmettre à la fois l'énergie nécessaire au circuit de commande et le signal de commande de conduction et de blocage du transistor de puissance Tp.

Le transformateur TR1 possède un enroulement primaire et deux enroulements secondaires, dont l'un est couplé au primaire avec deux transistors T1 et T2 pour constituer un oscillateur, et dont l'autre est isolé galvaniquememt du primaire pour alimenter le circuit de commande de base proprement dit.

L'oscillateur peut être mis en route ou bloqué à partir de deux entrées agissant sur les bases des transistors T1 et T2. Du côté du secondaire, un signal oscillant est reçu ou n'est pas reçu selon que l'oscillateur oscille ou non du côté du primaire. Le signal oscillant du secondaire, lorsqu'il existe, établit un courant de base positif rendant le transistor Tp conducteur. Lorsqu'il disparaît, un détecteur de seuil DS détecte cette disparition et rend momentanément conducteur un transistor T3 qui extrait un courant négatif de la base du transistor Tp, avec l'aide d'une capacité C qui s'était chargée pendant la conduction du transistor Tp.

Ce schéma a l'avantage de n'utiliser qu'un seul transformateur (petit car il fonctionne à haute fréquence: quelques dizaines de kilohertz) mais:
- d'une part il n'y a pas de possibilité de maintien d'une polarisation négative de la base de Tp pendant les périodes de blocage, puisque l'oscillateur n'oscille plus et ne fournit donc plus d'énergie au circuit de commande,
- et d'autre part la durée de conduction de Tp doit avoir une valeur minimale pour que la capacité C ait le temps de se charger suffisamment pour établir ensuite un courant négatif de blocage.

La présente invention propose un circuit de commande qui permet de résoudre au mieux l'ensemble des problèmes rencontrés dans les circuits connus.

Le circuit de commande, destiné à assurer la commutation d'un composant semiconducteur de puissance en fonction de l'état binaire d'un signal de commande de commutation, avec isolement galvanique entre ce signal de commande et le composant, comporte un transformateur ayant un enroulement primaire et au moins un enroulement secondaire, un oscillateur alimenté par une tension continue et fournissant un signal oscillant à l'enroulement primaire, un pont redresseur en sortie de l'enroulement secondaire, et un circuit à transistors alimenté par le pont redresseur et fournissant à une électrode de commande du composant de puissance soit un courant de mise en conduction du composant de puissance, soit un courant de blocage, selon le signal de commande.

Selon l'invention:
a) il est prévu un moyen pour appliquer à l'oscillateur une tension d'alimentation continue pouvant prendre deux valeurs différentes non nulles en fonction du signal de commande, les deux valeurs étant suffisantes pour assurer l'oscillation de l'oscillateur et l'alimentation normale par le pont redresseur du circuit à transistors relié à l'électrode de commande du composant de puissance,
b) un détecteur de niveau de tension est relié à la sortie du pont redresseur et commande le circuit à transistors pour établir soit un courant de mise en conduction, soit un courant de blocage, selon que le niveau de tension en sortie du pont redresseur correspond à une alimentation de l'oscillateur par la première valeur ou par la deuxième valeur de tension d'alimentation au primaire.

L'enroulement secondaire est en principe un enroulement à point-milieu, ce point définissant un potentiel de référence et le pont redresseur fournissant des tensions positive et négative pour l'alimentation du circuit a transistors.

Le circuit préférentiel selon l'invention va maintenant être décrit plus en détail en référence aux dessins annexés dans lesquels:
- les figures 1 à 3 déjà décrites représentent divers exemples de circuits de commande connus,
- la figure 4 représente le circuit selon l'invention.

Sur la figure 4, le composant semiconducteur dont la commutation est à assurer est un transistor de puissance Tp, de type NPN. Le circuit commandé par ce transistor n'est pas représenté. Seul le circuit de commande du transistor est représenté.

La commande s'effectue par un signal de commande binaire SC ayant deux états possibles, l'un établissant la mise en conduction du transistor Tp, l'autre établissant son blocage.

Il y a un isolement galvanique complet entre le signal de commande SC et le transistor Tp et cet isolement est assuré par un transformateur TR ayant ici trois enroulements pourvus chacun d'une prise intermédiaire en principe médiane.

Parmi les enroulements, on trouve un enroulement primaire EP1, un enroulement secondaire principal ES1 et un enroulement secondaire auxiliaire ES2. L'enroulement primaire EP1 et l'enroulement secondaire auxiliaire ES2 sont situés galvaniquement du côté du signal de commande SC. L'enroulement secondaire principal ES1 est situé galvaniquement du côté du transistor de puissance et la prise intermédiaire de cet enroulement est d'ailleurs reliée directement à l'émetteur du transistor de puissance; le potentiel de cet émetteur définit une référence par rapport à laquelle on verra que la base du transistor Tp peut être polarisée positivement ou négativement.

L'enroulement primaire EP1 du transformateur reçoit une énergie électrique alternative d'un circuit oscillant constitué d'une manière classique (que l'on retrouve pour l'essentiel sur la figure 3) à partir de deux transistors T1 et T2, de l'enroulement primaire EP1 lui-même et de l'enroulement secondaire auxiliaire ES2. Ce circuit oscillant est constitué de la manière suivante: les transistors ont leur émetteur relié à une masse (masse du côté du signal de commande), ont leur collecteur relié respectivement chacun à une extrémité de l'enroulement primaire, et ont leur base reliée respectivment chacune à une extrémité de l'enroulement auxiliaire; une résistance R1 relie le collecteur du transistor T1 à la base du transistor T2; une résistance R2 relie le collecteur du transistor T2 à la base du transistor T1; une résistance R3 relie la prise intermédiaire (médiane) de l'enroulement ES2 à la masse. Enfin, une tension continue d'alimentation est appliquée à la prise intermédiaire (médiane) de l'enroulement primaire EP1.

Le schéma de la figure 4 se distingue de celui de la figure 3 (pour la partie qui est située galvaniquement du côté du signal de commande) sur deux aspects: le premier est le fait qu'il n'y a pas sur la figure 4 de bornes de commande reliées aux bases des transistors pour établir ou arrêter l'oscillation de l'oscillateur; l'oscillateur oscille toujours; le deuxième est le fait que la tension d'alimentation sur la figure 4 n'est pas issue d'une source de polarisatiom fixe mais est issue d'une alimentation AL contrôlée par le signal de commande SC et susceptible de fournir, selon l'état de ce signal, deux tensions d'alimentation de valeurs differentes non nulles Va et Vb (de même signe évidemment, correspondant au type des tansistors T1 et T2: signe positif pour des transistors NPN).

En l'occurence, lorsque le signal de commande SC a un état correspondant à la conduction du transistor de puissance TP, la tension fournie par l'alimentation est Va; lorsque le signal SC a un état correspondant au blocage, la tension fournie est Vb supérieur a Va.

Les tensions Va et Vb sont toutes deux suffisantes pour assurer d'une part une oscillation stable de l'oscillateur (à une fréquence de quelques dizaines de kilohertz pour que le transformateur TR reste de petites dimensions) et d'autre part une transmission d'énergie suffisante à travers l'enroulement secondaire principal ES1, de sorte que le circuit alimenté par ce secondaire fonctionne normalement et permet une polarisation positive ou négative adéquate de la base du transistor Tp aussi bien lorsque la tension d'alimentation a la valeur Va que lorsqu'elle a la valeur Vb.

Du côté qui est relié galvaniquement au transistor Tp, on trouve un pont redresseur RD a quatre diodes disposé aux bornes de l'enroulement secondaire principal ES1, et des capacités de filtrage de faible valeur, respectivement C1 et C2, entre chaque sortie du pont redresseur RD et la prise médiane de l'enroulement secondaire.

Par rapport au potentiel de référence défini par cette prise médiane et appliqué à l'émetteur du transistor de puissance, le pont redresseur fournit donc des tensions d'alimentation redressées et filtrées, positives et négatives (en principe symétriques). La borne de sortie positive est désignée par la lettre A, la borne négative par la lettre B.

Un détecteur de niveau de tension DT est placé entre les bornes A et B pour indiquer si la tension redressée fournie par le pont correspond à une alimentation primaire par la tension Va ou au contraire à une alimentation primaire par la tension Vb.

Ce détecteur de niveau de tension commande un circuit à deux transistors T3 et T4, reliés à la base du transistor Tp, pour faire établir par ce circuit un courant de base positif, assurant la mise en conduction et le maintien en conduction du transistor Tp, lorsque la tension détectée correspond à une alimentation Va, et pour faire établir au contraire un courant de base négatif, assurant non seulement une extraction de courant de base nécessaire au blocage du transistor Tp, mais encore le maintien d'une polarisation de base négative provenant de la borne B, lorsque la tension détectée correspond à une alimentation Vb.

Le circuit à transistors ainsi commandé est très simple: il comprend un transistor T3 ayant son émetteur relié à la base du transistor de puissance, son collecteur relié à travers une résistance de limitation R4 à la borne de sortie positive A du pont redresseur, et sa base reliée par une résistance de polarisation R5 à cette borne A.

Une diode D est montée en antiparallèle aux bornes de la jonction base-émetteur du transistor T3, c'est-à-dire que pour un transistor NPN l'anode de la diode est reliée à l'émetteur et sa cathode à la base.

Un transistor T4 a sa base reliée à la sortie du détecteur de niveau DT, son émetteur relié à la borne B et son collecteur relié à la base du transistor T3.

Le détecteur de niveau de tension peut également être très simple: il comprend sur la figure 4 une diode zener Z en série avec un pont de résistances de limitation de courant R6, R7, le tout relié entre les bornes A et B, la sortie du détecteur étant prise au point de jonction des résistances R6 et R7.

Lorsque l'alimentation au primaire se fait avec la tension Va, la diode zener reste bloquée, la tension d'alimentation entre les bornes A et B étant inférieure à la tension nominale de cette diode. Le transistor T4 reste bloqué car sa base ne reçoit aucun courant; le transistor T3 est au contraire normalement polarisé et fournit à partir de la borne A un courant de base positif maintenant le transistor Tp conducteur.

Lorsque l'alimentation au primaire se fait avec la tension Vb, la diode zener est passante car la tension entre les bornes A et B est maintenant supérieure à sa tension nominale; le transistor T4 devient fortement conducteur, son collecteur passe au potentiel de la borne B (négatif), ce qui a pour effet d'une part d'abaisser le potentiel de la base du transistor T3 au-dessous du potentiel de son émetteur et donc de le bloquer, et d'autre part d'extraire un courant négatif de la base du transistor Tp à travers la diode D, extraction qui est nécessaire pour assurer un blocage rapide du transistor Tp.

Après cette extraction d'un courant négatif de base, durant le temps de déstockage des porteurs accumulés dans les jonctions du transistor Tp, le transistor T4 conducteur maintient une polarisation négative de la base du transistor Tp jusqu'à ce que le signal de commande SC change d'état et ramène la tension d'alimentation du primaire à Va.

Le circuit qui vient d'être décrit est tout à fait applicable à la commande d'autres éléments semiconducteurs et tout particulièrement à la commande de thyristors blocables par la gâchette.

## Revendications

1. Circuit de commande de commutation d'un composant semiconducteur de puissance (Tp) en fonction de l'état binaire d'un signal de commande de commutation (SC), avec isolement galvanique entre ce signal de commande et le composant, ce circuit comprenant un transformateur (TR) ayant un enroulement primaire (EP1) et au moins un enroulement secondaire (ES1), un oscillateur (T1, T2, R1, R2, EP1, ES2) alimenté par une tension continue et fournissant un signal oscillant à l'enroulement primaire, un pont redresseur (RD) en sortie de l'enroulement secondaire (ES1), et un circuit à transistors (T3, T4) alimenté par le pont redresseur et fournissant à une électrode de commande du composant de puissance soit un courant de mise en conduction soit un courant de blocage selon le signal de commande, caractérisé en ce que:

- a) il est prévu un moyen pour appliquer à l'oscillateur une tension d'alimentation pouvant prendre deux valeurs différentes non nulles (Va, Vb) en fonction de l'état binaire du signal de commande, les deux valeurs étant suffisantes pour assurer l'oscillation de l'oscillateur et l'alimentation normale par le pont redresseur du circuit à transistors relié à l'électrode de commande du composant de puissance

- b) un détecteur de niveau de tension (DT) est relié à la sortie du pont redresseur et commande le circuit à transistors pour établir soit un couranit de mise en conduction, soit un courant de blocage selon que le niveau de tension en sortie du pont redresseur correspond à une alimentation de l'oscillateur par la première valeur (Va) ou par la deuxième valeur (Vb) de tension d'alimentation.

2. Circuit de commande selon la revendication 1, caractérisé en ce que l'enroulement secondaire comporte une prise médiane reliée au composant de puissance, notamment à l'émetteur s'il s'agit d'un transistor.

3. Circuit selon la revemdication 1, caractérisé en ce que la valeur de tension d'alimentation (Va) correspondant à l'établissement d'un courant de blocage est supérieure à celle (Vb) qui correspond à un courant de mise en conduction.

4. Circuit selon la revendication 1, caractérisé en ce que le circuit à transistors comprend un premier transistor (T3) alimenté à partir d'une sortie (A) du pont redresseur et relié à l'électrode de commande du composant de puissance, pour fournir un courant de mise en conduction de ce dernier, et un deuxième transistor, (T4) alimenté à partir de l'autre sortie (B) du pont redresseur et également relié à l'électrode de commande, pour extraire un courant négatif de blocage du composant de puissance.

5. Circuit selon la revendication 1, caractérisé en ce que le détecteur de niveau est constitué essentiellement par une diode zener (Z) en série avec des résistances de limitation de courant (R6, R7).

6. Circuit selon la revendication 1, caractérisé en ce qu'il comporte:
- un premier transistor (T3) dont l'émetteur est relié à l'électrode de commande du transistor de puissance (Tp) dont le collecteur est relié à travers une résistance (R4) à une première sortie (A) du pont redresseur, et dont la base est également reliée à travers une autre résistance (R5) à cette première sortie,
- un deuxième transistor (T4) dont l'émetteur est relié à une deuxième sortie (B) du pont redresseur, dont le collecteur est relié à la base du premier transistor (T3), et dont la base est reliée, à travers une résistance (R6) à une diode zener (Z) reliée par ailleurs à la première sortie (A) du pont redresseur,
- une diode (D) en antiparallèle sur la jonction base-émetteur du premier transistor,
- le composant de puissance étant par ailleurs relié à une prise médiane de l'enroulement secondaire.

## Patentansprüche

1. Steuerschaltkreis zur Umschaltung eines Leistungshalbleiterbauteils (Tp) abhängig vom Binärzustand eines Umschaltsteuersignals (SC) mit galvanischer Isolierung zwischen diesem Steuersignal und dem Bauteil, wobei der Schaltkreis einen Transformator (TR) mit einer Primärwicklung EP1) und mindestens einer Sekundärwicklung (ES1), einen Oszillator (T1, T2, R1, R2, EP1, ES2), der mit einer Gleichspannung gespeist wird und ein Schwingsignal an die Primärwicklung·liefert, eine Gleichrichterbrücke (RD) am Ausgang der Sekundärwicklung (Es1) und einen Schaltkreis mit Transistoren (T3, T4) aufweist, der von der Gleichrichterbrücke gespeist wird und an eine Steuerelektrode des Leistungsbauteils je nach dem Steuersignal entweder einen Durchschaltestrom oder einen Sperrstrom liefert, dadurch gekennzeichnet, daß:

- a) ein Mittel zum Anlegen einer Speisespannung an den Oszillator vorgesehen ist, die zwei von Null verschiedene unterschiedliche Werte (Va, Vb) abhängig vom Binärzustand des Steuersignals annehmen kann, wobei beide Werte ausreichen, um das Schwingen des Oszillators und die normale Stromversorgung des an die Steuerelektrode des Leistungsbauteils angeschlossenen Transistorkreises über die Gleichrichterbrücke sicherzustellen,

- b) ein Spannungspegeldetektor (DT) an den Ausgang der Gleichrichterbrücke angeschlossen ist und den Transistorkreis steuert, um entweder einen Durchschaltestrom oder einen Sperrstrom zu erzeugen, je nachdem, ob der Spannungspegel am Ausgang der Gleichrichterbrücke einer Speisung des Oszillators mit dem ersten Wert (Va) oder mit dem zweiten Wert (Vb) der Speisespannung entspricht.

2. Steuerkreis nach Anspruch 1, dadurch gekennzeichnet, daß die Sekundärwicklung einen Mittelabgriff besitzt, der an das Leistungsbauteil angeschlossen ist, insbesondere an den Emitter, falls es sich um einen Transistor handelt.

3. Schaltkreis nach Anspruch 1, dadurch gekennzeichnet, daß der Wert der Speisespannung (Va), der der Erzeugung eines Sperrstroms entspricht, größer als der (Vb) ist, der einem Durchschaltestrom entspricht.

4. Schaltkreis nach Anspruch 1, dadurch gekennzeichnet, daß der Transistorkreis einen ersten Transistor (T3), der von einem Ausgang (A) der Gleichrichterbrücke gespeist wird und an die Steuerelektrode des Leistungsbauteils angeschlossen ist, um einen das Durchschalten dieses Transistors bewirkenden Strom zu liefern, und einen zweiten Transistor (T4) enthält, der vom anderen Ausgang (B) der Gleichrichterbrücke gespeist wird und ebenfalls an die Steuerelektrode angeschlossen ist, um einen negativen Strom zum Sperren des Leistungsbauteils aus diesem abzuziehen.

5. Schaltkreis nach Anspruch 1, dadurch gekennzeichnet, daß der Pegeldetektor im wesentlichen aus einer Zenerdiode (Z) in Reihe mit Strombegrenzerwiderständen (R6, R7) besteht.

6. Schaltkreis nach Anspruch 1, dadurch gekennzeichnet, daß er aufweist:

- einen ersten Transistor (T3), dessen Emitter an die Steuerelektrode des Leistungstransistors (Tp) angeschlossen ist, dessen Kollektor über einen Widerstand (R4) an einen ersten Ausgang (A) der Gleichrichterbrücke und dessen Basis über einen weiteren Widerstand (R5) ebenfalls an diesen ersten Ausgang angeschlossen ist,

- einen zweiten Transistor (T4), dessen Emitter an einen zweiten Ausgang (B) der Gleichrichterbrücke angeschlossen ist, dessen Kollektor an die Basis des ersten Transistors (T3) und dessen Basis über einen Widerstand (R6) an eine Zenerdiode (Z) angeschlossen ist, die außerdem mit dem ersten Ausgang (A) der Gleichrichterbrücke verbunden ist,

- eine Diode (D) in Gegenrichtung zum Basisemitterübergang des ersten Transistors,

- wobei das Leistungsbauteil weiter an einen Mittelabgriff der Sekundärwicklung angeschlossen ist.

## Claims

1. A circuit for controlling the switching operation of a semiconductor power component (Tp) in accordance with the binary state of a switch control signal (SC), including a galvanic separation between this control signal and the component, this circuit comprising a transformer (TR) having a primary winding (EP1), and at least one secondary winding (ES1), an oscillator (T1, T2, R1, R2, EP1, ES2) supplied with a direct voltage and delivering an oscillating signal to the primary winding, a rectifier bridge (RD) at the output of the secondary winding (ES1) and a transistorized circuit (T3, T4) fed by the rectifier bridge and supplying to a control electrode of the power component either a current for rendering it conductive or a current for blocking it in accordance with the control signal, characterized in that:

- a) a means is provided for applying to the oscillator and in accordance with the binary state of the control signal two different values (Va, Vb) which are not zero and which are conceived to ensure the oscillation of the oscillator and the normal voltage supply of the transistorized circuit via the rectifier bridge, the circuit being connected to the control electrode of the power component,

- b) a voltage level detector (DT) is connected to the output of the rectifier bridge and controls the transistorized corcuit in order to establish either a current for rendering it conductive or a current for blocking it according to whether the voltage level at the output of the rectifier circuit corresponds to a supply of the first value (Va) or of the second value (Vb) of the supply voltage to the oscillator.

2. A control circuit according to claim 1, characterized in that the secondary winding comprises an intermediate tap connected to the power component, especially to the emitter in the case of a transistor power component.

3. A circuit according to claim 1, characterized in that the value of the supply voltage (Va) corresponding to the establishment of a blocking current exceeds that (Vb) corresponding to a current for rendering the component conductive.

4. A circuit according to claim 1, characterized in that the transistorized circuit comprises a first transistor (T3) fed from an output (A) of the rectifier bridge and connected to the control electrode of the power component for supplying a current in order to render the latter conductive, and a second transistor (T4) fed from the other output (B) of the rectifier bridge and equally connected to the control electrode in order to extract a negative blocking current from the power component.

5. A circuit according to claim 1, characterized in that the level detector is substantially constituted by a Zener diode (Z) in series with current limiting resistors (R6, R7).

6. A circuit according to claim 1, characterized in that it comprises:

- a first transistor (T3), the emitter of which is connected to the control electrode of the power transistor (Tp), the collector of which is connected via a resistor (R4) to a first output (A) of the rectifier bridge and the base of which is also connected via a further resistor (R5) to this first output,

- a second transistor (T4), the emitter of which is connected to a second output (B) of the rectifier bridge, the collector of which is connected to the base of the first transistor (T3) and the base of which is connected via a resistor (R6) to a Zener diode (Z), the latter further being connected to the first output (A) of the rectifier bridge,

- a diode (D) reversely branched in parallel to the base-emitter junction of the first transistor,

- the power component being further connected to an intermediate tap of the secondary winding.

Fig.1

Fig.2

Fig.3

Fig.4